# EUROPEAN PATENT APPLICATION

(11) **EP 4 745 660 A1**
(43) Date of publication of application: **20.05.2026**
(21) Application number: 24212813.0
(22) Date of filing: 13.11.2024
(51) Int. Cl.: G02F 1/225, G02B 6/42, H01L 23/522, G02B 6/13

(54) **PHOTONIC INTEGRATED CIRCUIT AND OPTO-ELECTRONIC SYSTEM COMPRISING THE SAME**

(71) Applicant: EFFECT Photonics B.V., 5656 AE Eindhoven (NL)
(72) Inventor: Sadiq, Muhammad Usman, 5656AE Eindhoven (NL); Kelly, Niall Patrick, 5656AE Eindhoven (NL)
(74) Representative: Kramer-Ograjensek, Petra

(57) **Abstract**

The invention relates to a photonic integrated circuit (1) comprising bond pads (19), RF components (20), a first layer stack (4) having a doped epitaxial semiconductor layer (5), a second layer stack (8) that is associated with the first layer stack, and a first set of elongated tracks (18a, 18b) of electrically conductive material that are associated with the second layer stack and in use of the photonic integrated circuit can carry an RF signal between the bond pads and the RF components. The second layer stack comprises an electrical ground shield (12) that is sandwiched between a first dielectric layer (9) and a second dielectric layer (15). In use of the photonic integrated circuit, the electrical ground shield minimizes or prevents overlap between an electric field caused by said RF signal and said doped epitaxial semiconductor layer.

The invention also relates to an opto-electronic system (100) comprising said photonic integrated circuit.

## Description

### FIELD OF THE INVENTION

The present invention relates to a photonic integrated circuit. The invention also relates to an opto-electronic system comprising the photonic integrated circuit according to the invention. The opto-electronic system according to the invention can be used for example, but not exclusively, for telecommunication applications, Light Detection and Ranging (LIDAR) or sensor applications.

### BACKGROUND OF THE INVENTION

The continuous development of new and improved opto-electronic systems that can be used for example, but not exclusively, for telecommunication applications, Light Detection and Ranging (LIDAR) or sensor applications, is primarily driven by, one the one hand, optimization of module bandwidth (bitrate) to meet market demands and, on the other hand, increasing photonic chip complexity to reduce costs and leverage smaller module form factors. As a result, interesting challenges arise with respect to designing required radio frequency (RF) photonic integrated circuits and associated opto-electronic systems. For example, in the case of a typical traveling wave modulator system, it is not sufficient to simply design an RF modulator, driver electronics and an RF termination. It is also important to carefully consider the impedance of the elongated metal tracks that are used as on-chip electrical interconnects or feedlines in order to maximize the performance of the traveling wave modulator system as a whole. Failure to do so will result in electrical reflections and losses that prevent achieving the desired maximum performance of the traveling wave modulator system as a whole.

Regarding photonic integrated circuits, on-chip electrical interconnects or feedlines are typically configured as elongated metal tracks that are arranged along the surface of a photonic integrated circuit for interconnecting bond pads and RF components. Unlike off-chip electrical interconnects, which are often designed on low-loss printed circuit boards, on-chip electrical interconnects or feedlines must be designed having regard to negative effects of a doped semiconductor layer, which is arranged underneath an on-chip electrical interconnect, on an RF signal that in the event that the photonic integrated circuit is in use is carried by said on-chip electrical interconnect due to an overlap of an electric field that is caused by the RF signal and the doped semiconductor layer. As a result, an on-chip electrical interconnect or feedline for a high-bandwidth photonic integrated circuit has a length that preferably is kept as short as possible to reduce electrical insertion losses.

Although this design approach can be successful for photonic integrated circuits having a simple layout, this approach is not viable for photonic integrated circuits having an increasingly complex layout. For example, in photonic integrated circuits having a more complex design, the on-chip electrical interconnects or feedlines may need to be implemented as elongated metal tracks as a result of restrictions regarding allowed locations for electrical interfaces around the photonic integrated circuit relative to the RF components that need to be electrically connected with said electrical interfaces. Furthermore, optical routing restrictions can require the on-chip electrical interconnects or feedlines to cross over on-chip optical waveguides. This can induce increased losses to the RF signals that are carried by said on-chip electrical interconnects if the photonic integrated circuit is in use.

Typical approaches for reducing the above-mentioned problems associated with the design of on-chip electrical interconnects or feedlines for photonic integrated circuits having an increasingly complex layout involve deposition of thick electrically insulating polymer layers, removal of doped semiconductor layers and application of air bridges.

Deposition of a thick electrically insulating polymer layer having a low dielectric constant between the on-chip electrical interconnects or feedlines and underlying doped semiconductor layers of the photonic integrated circuit can reduce insertion losses. However, a disadvantage of this approach is that the number of suitable polymers that can withstand semiconductor fabrication processes, e.g. dry etching, wet etching, temperature ranges etc., is limited. As a result, the range of suitable dielectric constants is limited. Another disadvantage is that an extremely thick polymer layer increases the topology the on-chip electrical interconnects or feedlines must traverse in order to enable establishment of electrical contacts with the underlying photonic elements. Yet another disadvantage of thick polymer layers is that they can introduce strain on the photonic integrated circuit. The above-mentioned disadvantages give rise to yield and reliability challenges for the photonic integrated circuits and associated opto-electronic systems in which the photonic integrated circuits are applied. The afore-mentioned disadvantages of the application of a thick polymer layer become increasingly evident for longer feedlines as the negative effects become larger with increased surface area of the feedlines.

Removal of the doped semiconductor layers underneath the on-chip electrical interconnects or feedlines can be achieved by etching trenches in the doped semiconductor layers that provide access to the underlying semi-insulting substrate of the photonic integrated circuit. Although this approach enables reduction of the above-mentioned losses to the RF signals that are carried by said on-chip electrical interconnects if the photonic integrated circuit is in use, it gives rise to fabrication issues. For example, a disadvantage of this approach is that providing large trenches can negatively affect the etch loading during processing. In addition, the provision of large trenches can cause resist pooling which can negatively affect lithographic resolution. Removal of the doped semiconductor layers is not an option in regions of the photonic integrated circuit in which the on-chip electrical interconnects or feedlines need to cross over on-chip optical waveguides.

In order to enable an on-chip electrical interconnect or feedline to cross over an on-chip optical waveguide, at least the part of the on-chip electrical interconnect or feedline crossing over the on-chip optical waveguide could be arranged as an air bridge, i.e. a suspended electrically conductive structure. A disadvantage associated with air bridges is that their fabrication involves removal of sacrificial electrically insulating supporting material, which initially is arranged underneath at least the part of the on-chip electrical interconnect that must cross over for example the on-chip optical waveguide, to obtain at least a partially suspended on-chip electrical interconnect or feedline that is referred to as an air bridge. Another disadvantage associated with air bridges is the very short distance that can be bridged due to structural limitations of the air bridges. Yet another disadvantage of the application of air bridges is that they can give rise to yield and reliability problems due to breakage of the air bridges for example during removal of the sacrificial electrically insulating supporting material.

In view of the above, it is clear that each of the typical approaches for reducing the above-mentioned problems associated with the design and implementation of on-chip electrical interconnects or feedlines for photonic integrated circuits having an increasingly complex layout is advantageous in a specific situation and hence does not provide a so-called one-fits-all-solution. In addition, the typical approaches can give rise to yield and reliability problems of the photonic integrated circuit in which they are applied. Therefore, there is a need for providing a photonic integrated circuit comprising structural features that can pre-empt or at least reduce the above-mentioned and/or other disadvantages associated with the design and implementation of on-chip electrical interconnects or feedlines in increasingly complex high-bandwidth photonic integrated circuits.

### SUMMARY OF THE INVENTION

It is an object of the present invention to provide a photonic integrated circuit comprising structural features that can pre-empt or at least reduce at least one of the above-mentioned and/or other disadvantages associated with the design and implementation of on-chip electrical interconnects or feedlines in increasingly complex high-bandwidth photonic integrated circuits.

It is another object of the present invention to provide an opto-electronic system comprising a photonic integrated circuit according to the invention. The opto-electronic system according to the invention can be used for example, but not exclusively, for telecommunication applications, LIDAR or sensor applications.

Aspects of the present invention are set out in the accompanying independent and dependent claims. Features from the dependent claims may be combined with features from the independent claim as appropriate and not merely as explicitly set out in the claims. Furthermore, all features may be replaced with other technically equivalent features.

At least one of the abovementioned objects is achieved by a photonic integrated circuit comprising:
- an InP-based substrate having a first surface;
- a first layer stack that comprises a doped epitaxial semiconductor layer, the first layer stack being configured and arranged to provide optical functionality if the photonic integrated circuit is in use, the first layer stack having:
   - a second surface that is associated with the first surface of the InP-based substrate; and
   - a third surface that is arranged to face away from the second surface; and
- a second layer stack that is configured and arranged to provide electrical functionality if the photonic integrated circuit is in use, the second layer stack comprising:
   - a first dielectric layer having:
      ∘ a fourth surface that is associated with the third surface of the first layer stack; and
      ∘ a fifth surface that is arranged to face away from the fourth surface;
   - an electrical ground shield having:
      ∘ a sixth surface that is associated with the fifth surface of the first dielectric layer; and
      ∘ a seventh surface that is arranged to face away from the sixth surface;
   - a second dielectric layer having:
      ∘ an eighth surface that is associated with the seventh surface of the electrical ground shield; and
      ∘ a ninth surface that is arranged to face away from the eighth surface;
- a first set of elongated tracks of electrically conductive material that are associated with the ninth surface of the second dielectric layer of the second layer stack, the first set of elongated tracks of electrically conductive material being configured and arranged to carry an RF signal if the photonic integrated circuit is in use; and
- at least one electrical bond pad and at least one RF component that are electrically associated with each other via the first set of elongated tracks of electrically conductive material;
wherein the first dielectric layer of the second layer stack is configured and arranged to provide DC electrical isolation between the electrical ground shield and the first layer stack if the photonic integrated circuit is in use, and wherein the electrical ground shield is configured and arranged to minimize or prevent overlap between an electric field that is caused by said RF signal and the doped epitaxial semiconductor layer of the first layer stack if the photonic integrated circuit is in use.

In this way, the photonic integrated circuit according to the invention comprises on-chip electrical interconnects or feedlines that are implemented using a shielded on-chip electrical interconnect or feedline approach. It is noted that from the wording of the above-defined embodiment of the photonic integrated circuit according to the invention, it is clear that the elongated tracks of the first set of elongated tracks of electrically conductive material that electrically interconnect the at least one bond pad and the at least one RF component of the photonic integrated circuit are to be construed as on-chip electrical interconnects or feedlines.

The shielded on-chip electrical interconnect or feedline approach that is applied in the photonic integrated circuit according to the invention minimizes or prevents an overlap between the doped epitaxial semiconductor layer of the photonic integrated circuit and the electric field of an RF signal that is carried by the on-chip electrical interconnects or feedlines, if the photonic integrated circuit is in use, without the need for applying at least one of the above-mentioned disruptive isolation trenches, impractically thick polymer layers and fragile air bridges. The shielded on-chip electrical interconnect or feedline approach enables long, i.e. in a range from 0.5mm to 5mm, low-loss on-chip electrical interconnects or feedlines of desired impedance for use in photonic integrated circuits having increasingly complex layouts. The long shielded on-chip electrical interconnects or feedlines can route over photonic components such as on-chip optical waveguides without any performance penalty. It is noted that the shielded on-chip electrical interconnects or feedlines of the photonic integrated circuit according to the invention are suitable for application with any kind of RF component, for example Mach-Zehnder modulators (MZMs), electro-absorption modulators (EAMs) and RF photodiodes (RF PDs).

The electrically conductive material that is used for the elongated tracks of the first set of elongated tracks can be any kind of electrically conductive material having any suitable composition and dimensions as long as a high-quality RF signal can be carried, if the photonic integrated circuit is in use, between the bond pads and the RF components of the photonic integrated circuit. It is noted that the composition and the dimensions of the elongated tracks of the first set of elongated tracks of electrically conductive material are dictated by a desired electrical impedance of the on-chip electrical interconnects or feedlines and fabrication process tolerances. A practical example is that an elongated track of the first set of elongated tracks is fabricated using electroplated gold as the electrically conductive material. The electroplated gold track of the first set of elongated tracks can have a first width (W₁) as seen in a direction parallel to the InP-based substrate of 10µm, and a first thickness (T₁) of 3µm to achieve an on-chip electrical interconnect or feedline having an impedance of 55 Ohm. It is noted that any other dimensions and composition of the electrically conductive material can be envisaged depending on the specific technical requirements of the photonic integrated circuit. It is noted that the shielding performance of the electrical ground shield is not influenced by the dimensions and/or composition of the elongated tracks of the first set of elongated tracks of electrically conductive material. The electrical ground shield can have a second thickness (T₂) as seen in the direction perpendicular to the InP-based substrate. The second thickness (T₂) can be in a range from 50nm to 4µm. A disadvantage of an electrical ground shield having a second thickness (T₂) that is larger than 4µm is that topology and/or reliability issues can arise without any improvement in performance. A disadvantage of an electrical ground shield having a second thickness (T₂) that is smaller than 50nm is that performance is compromised due to a too high resistivity.

It is noted that the degree of coupling between the electrical ground shield and the electric field that is associated with the RF signal that, if the photonic integrated circuit is in use, is carried by the first set of elongated tracks of the first set of elongated tracks of electrically conductive material can be influenced by the composition and a third thickness (T₃) as seen in the direction perpendicular to the InP-based substrate of the second dielectric layer in the arrangement of the electrical ground shield, the second dielectric layer and the elongated tracks of the first set of elongated tracks of electrically conductive material in accordance with the above-defined embodiment of the photonic integrated circuit according to the invention. For example, if the elongated tracks of the first set of elongated tracks of electrically conductive material have a first thickness (T₁) of for example 3µm and the second dielectric layer comprises benzocyclobutene (BCB) having a third thickness (T₃) of for example 3µm, the electric field associated with the RF signal that, if the photonic integrated circuit is in use, is carried by the first set of elongated tracks of electrically conductive material, can be considered as tightly coupled to the electrical ground shield. In addition, it is noted that the composition and the third thickness (T₃) of the second dielectric layer can influence the impedance of the on-chip electrical interconnects or feedlines. Therefore, the composition and the third thickness (T₃) of the second dielectric layer need to be carefully chosen and/or controlled. The above-mentioned example of a second dielectric layer that comprises benzocyclobutene (BCB) and has a third thickness (T₃) of 3µm can be used to achieve on-chip electrical interconnects or feedlines having an impedance of 55 Ohm. It will be clear that the value for the impedance of the on-chip electrical interconnects or feedlines and therefore the composition and dimensions of the second dielectric layer depend on the actual use case of the photonic integrated circuit.

As mentioned above, if the photonic integrated circuit is in use, the first dielectric layer provides DC electrical isolation between the electrical ground shield and the first layer stack that comprises the doped epitaxial semiconductor layer. Although it would be sufficient if the first dielectric layer has a fourth thickness (T₄) as seen in the direction perpendicular to the InP-based substrate of for example 20nm, for planarization purposes it would be advantageous if the first dielectric layer has a fourth thickness (T₄) of for example 3µm. As such, the first dielectric layer would also have planarizing functionality that can improve the yield and reliability of the photonic integrated circuit.

Based on all of the above, it is clear that the photonic integrated circuit according to the invention that comprises on-chip electrical interconnects or feedlines that have been implemented in accordance with the shielded on-chip electrical interconnect or feedline approach, pre-empts the above-described problems associated with the typical approaches for reducing the above-mentioned problems associated with the implementation of on-chip electrical interconnects or feedlines in photonic integrated circuits having an increasingly complex layout. In particular, it is appreciated that the shielded on-chip electrical interconnect or feedline approach allows easier processing of the photonic integrated circuit. In addition, the shielded on-chip electrical interconnect or feedline approach provides a one-fits-all solution for the above-described specific situations, e.g. on-chip electrical interconnects that are arranged over doped epitaxial semiconductor layers and/or have to cross over on-chip optical waveguides.

In an embodiment of the photonic integrated circuit according to the invention, the electrical ground shield of the second layer stack is configured as a continuous sheet of electrically conductive material.

A continuous sheet of electrically conductive material is the simplest implementation of the electrical ground shield that provides the desired electrical shielding of the elongated tracks of the first set of elongated tracks of electrically conductive material, i.e. the on-chip electrical interconnects or feedlines, from the doped epitaxial semiconductor layer of the first layer stack of the photonic integrated circuit according to the invention. However, application of the electrically conductive material constituting the electrical ground shield as a continuous sheet can introduce reliability issues. Especially if the continuous sheet has an area that covers most or all of the underlying layers, trapping of outgassed material from the underlying layers underneath the continuous sheet can lead to failure points that compromise the yield and reliability of the photonic integrated circuit.

It is noted that any kind of electrically conductive material having any suitable composition and dimensions can be used for establishing the electrical ground shield as a continuous sheet as long as the electrically conductive material can achieve electromagnetic shielding. Examples of suitable materials include metals, degenerate semiconductors, electrically conductive polymers, metal-organic frameworks and coordination polymers. Metal-organic frameworks are defined as crystalline compounds consisting of metal ions or clusters coordinated to often rigid organic molecules to form one-, two-, or three-dimensional structures that can be porous. Coordination polymers are inorganic or organometallic polymer structures comprising metal cation centers linked by ligands.

In an embodiment of the photonic integrated circuit according to the invention, the electrical ground shield of the second layer stack is configured as a meshed grid of electrically conductive material.

It is noted that configuring the electrical ground shield as a meshed grid of electrically conductive material can remedy the above-mentioned disadvantage of establishing the electrical ground shield as a continuous sheet of electrically conductive material. In addition, a meshed grid of electrically conductive material can offer improved fabrication tolerance because a continuous sheet of electrically conductive material can peel off more easily during the fabrication process than a meshed grid of electrically conductive material. Furthermore, the meshed grid of electrically conductive material can help to relieve additional stress or strain build-up in the electrical ground shield during reliability testing of the photonic integrated circuit.

The meshed grid can be established by providing a continuous layer of an electrically conductive material with through-holes. The though-holes can be configured and arranged to provide the meshed grid with a uniform mesh size, a non-uniform mesh size or regions with a uniform mesh size and regions with a non-uniform mesh size. It is also possible to interconnect elongated tracks of an electrically conductive material using a mesh pattern to establish a meshed grid. The elongated tracks of electrically conductive material can be arranged relative to each other to establish a uniform mesh size, a non-uniform mesh size or regions with a uniform mesh size and regions with a non-uniform mesh size.

It is noted that any kind of electrically conductive material having any suitable composition and dimensions can be used for establishing the meshed grid as long as the electrically conductive material can achieve electromagnetic shielding. Examples of suitable materials include metals, degenerate semiconductors, electrically conductive polymers, metal-organic frameworks and coordination polymers.

In an embodiment of the photonic integrated circuit according to the invention, the meshed grid of electrically conductive material is configured to have a maximum mesh size that is equal to one tenth of a wavelength of said RF signal that is carried by the first set of elongated tracks of electrically conductive material if the photonic integrated circuit is in use. Typically, the maximum mesh size is in the order of a few millimeters. A minimum mesh size is usually dictated by process limitations. A minimum mesh size equal to zero would actually result in a continuous sheet of electrically conductive material.

In an embodiment of the photonic integrated circuit according to the invention, the electrical ground shield of the second layer stack is configured as a second set of elongated tracks of electrically conductive material that are interconnected via a meshed grid of electrically conductive material.

In this way the electrical ground shield is established in a hybrid way, i.e. by using continuous tracks of electrically conductive material that are interconnected by a meshed grid of electrically conductive material. It is noted that any kind of electrically conductive material having any suitable composition and dimensions can be used for establishing the elongated tracks of the second set of elongated tracks that are interconnected by a meshed grid as long as the electrically conductive material can achieve electromagnetic shielding. Examples of suitable materials include metals, degenerate semiconductors, electrically conductive polymers, metal-organic frameworks and coordination polymers.

In an embodiment of the photonic integrated circuit according to the invention, an elongated track of the second set of elongated tracks of electrically conductive material is arranged underneath an elongated track of the first set of elongated tracks of electrically conductive material. It is noted that the elongated tracks of the second set of elongated tracks of electrically conductive material can also be arranged to cover optical waveguide crossings.

In an embodiment of the photonic integrated circuit according to the invention, a respective elongated track of the second set of elongated tracks of electrically conductive material that is arranged underneath a respective elongated track of the first set of elongated tracks of electrically conductive material has a respective second width (W₂) as seen in a direction parallel to the InP-based substrate, and the respective elongated track of the first set of elongated tracks of electrically conductive material has a first width (W₁) as seen in the direction parallel to the InP-based substrate, wherein the second width (W₂) is larger than the first width (W₁).

The second width (W₂) can be at least 75% larger than the first width (W₁). The first width (W₁) can be in a range from 5µm to 15µm depending amongst others on specific requirements regarding the desired impedance of the elongated track of the first set of elongated tracks of electrically conductive material.

In an embodiment of the photonic integrated circuit according to the invention, the electrically conductive material comprises metal. It is noted that any metal having a high electrical conductivity can be used provided that the metal is compatible with InP processing and does not give rise to yield and/or reliability issues.

In an embodiment of the photonic integrated circuit according to the invention, the metal comprises gold. It is noted that the metal alloy comprising gold must be compatible with InP processing and should not give rise to yield and/or reliability issues.

In an embodiment of the photonic integrated circuit according to the invention, the electrically conductive material is gold. Gold is advantageous due to its high electrical conductivity and compatibility with InP processing.

In an embodiment of the photonic integrated circuit according to the invention, the first layer stack comprises a non-intentionally doped epitaxial semiconductor layer that is arranged with respect to said doped epitaxial semiconductor layer to provide the photonic integrated circuit with an optical waveguide.

In an embodiment of the photonic integrated circuit according to the invention, the non-intentionally doped epitaxial semiconductor layer is an InₓGa₁₋ₓAs_{y}P_{1-y} core layer of the optical waveguide and the doped epitaxial semiconductor layer is a p-type doped InP-based cladding layer of the optical waveguide.

In an embodiment of the photonic integrated circuit according to the invention, the fourth surface of the first dielectric layer of the second layer stack is associated with the third surface of the first layer stack via a third dielectric layer, wherein the first dielectric layer and the third dielectric layer comprise different materials.

The first dielectric layer can be a polymer layer, e.g. benzocyclobutene (BCB). The fourth thickness (T₄) of the first dielectric layer can be in a range from 500nm to 3µm, for example 1.5µm. The third dielectric layer can be an oxide containing material, e.g. silicon dioxide (SiO₂) having a fifth thickness (T₅) as seen in the direction perpendicular to the InP-based substrate. The fifth thickness (T₅) can be in a range from 20nm to 300nm, for example 150nm.

In an embodiment of the photonic integrated circuit according to the invention, the eighth surface of the second dielectric layer of the second layer stack is associated with the seventh surface of the electrical ground shield of the second layer stack via a fourth dielectric layer, wherein the second dielectric layer and the fourth dielectric layer comprise different materials.

The second dielectric layer can be a polymer layer, e.g. benzocyclobutene (BCB). The third thickness (T₃) of the second dielectric layer can be in a range from 1 µm to 5µm, for example 3µm. The fourth dielectric layer can be an oxide containing material, e.g. silicon dioxide (SiO₂) having a sixth thickness (T₆) as seen in the direction perpendicular to the InP-based substrate. The sixth thickness (T₆) can be in a range from 50nm to 500nm, for example 300nm.

According to another aspect of the present invention, an opto-electronic system is provided comprising a photonic integrated circuit according to the invention, wherein the opto-electronic system is one of a transmitter, a receiver, a transceiver, a coherent transmitter, a coherent receiver and a coherent transceiver. The opto-electronic system can for example, but not exclusively, be used for telecommunication applications, LIDAR or sensor applications. Based on the above, the person skilled in the art will appreciate that any one of the above-mentioned transmitters, receivers and transceivers can benefit from the advantages provided by the photonic integrated circuit according to the present invention.

### BRIEF DESCRIPTION OF THE DRAWINGS

Further features and advantages of the invention will become apparent from the description of exemplary and non-limiting embodiments of a photonic integrated circuit and an opto-electronic system according to the present invention.

The person skilled in the art will appreciate that the described embodiments of the photonic integrated circuit and the opto-electronic system are exemplary in nature only and not to be construed as limiting the scope of protection in any way. The person skilled in the art will realize that alternatives and equivalent embodiments of the photonic integrated circuit and the opto-electronic system can be conceived and reduced to practice without departing from the scope of protection of the present invention.

Reference will be made to the figures on the accompanying drawing sheets. The figures are schematic in nature and therefore not necessarily drawn to scale. Furthermore, equal reference numerals denote equal or similar parts. On the attached drawing sheets,
figure 1 shows a schematic cross-section of a first exemplary, non-limiting embodiment of a photonic integrated circuit according to the present invention;
figure 2 shows a schematic cross-section of a second exemplary, non-limiting embodiment of the photonic integrated circuit according to the present invention;
figure 3 shows a schematic cross-section of a third exemplary, non-limiting embodiment of the photonic integrated circuit according to the present invention;
figure 4 shows a schematic cross-section of a fourth exemplary, non-limiting embodiment of the photonic integrated circuit according to the present invention;
figure 5 shows a schematic top view of a portion of a photonic integrated circuit according to the present invention, wherein two elongated tracks of a first set of elongated tracks of electrically conductive material are arranged relative to a first exemplary, non-limiting embodiment of an electrical ground shield, wherein for the sake of clarity of representation any dielectric layer that is arranged between the two elongated tracks and the electrical ground shield is omitted;
figure 6 shows a schematic top view of a portion of a photonic integrated circuit according to the present invention, wherein two elongated tracks of the first set of elongated tracks of electrically conductive material are arranged relative to a second exemplary, non-limiting embodiment of the electrical ground shield, wherein for the sake of clarity of representation any dielectric layer that is arranged between the two elongated tracks and the electrical ground shield is omitted;
figure 7 shows a schematic top view of a portion of a photonic integrated circuit according to the present invention, wherein two elongated tracks of the first set of elongated tracks of electrically conductive material are arranged relative to a third exemplary, non-limiting embodiment of the electrical ground shield, wherein for the sake of clarity of representation any dielectric layer that is arranged between the two elongated tracks and the electrical ground shield is omitted; and
figure 8 shows a schematic top view of a first exemplary, non-limiting embodiment of an opto-electronic system according to the present invention that comprises the photonic integrated circuit according to the present invention.

### DETAILED DESCRIPTION OF EMBODIMENTS

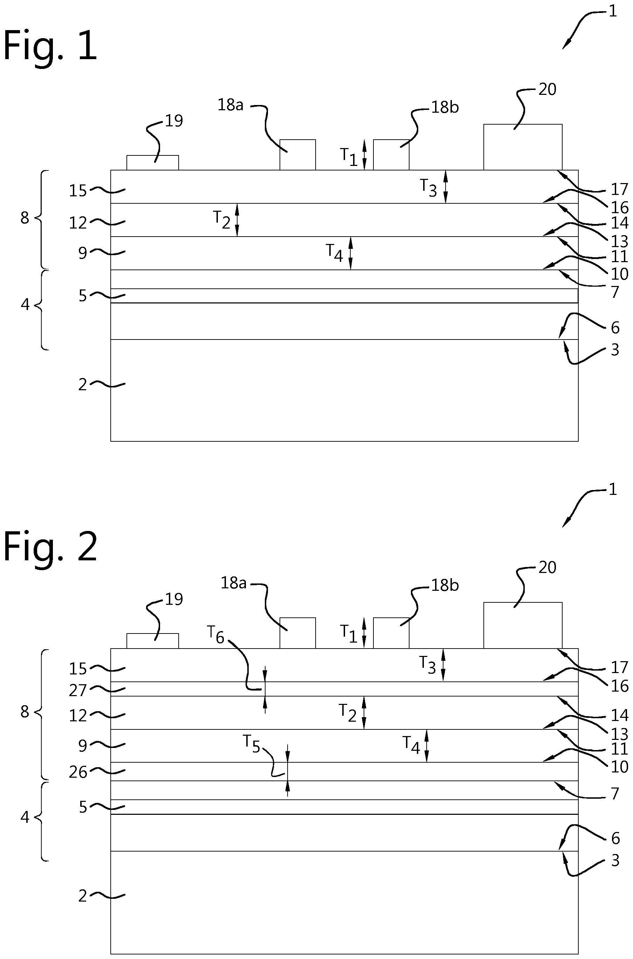

Figure 1 shows a schematic cross-section of a first exemplary, non-limiting embodiment of a photonic integrated circuit 1 according to the present invention. The photonic integrated circuit 1 comprises an InP-based substrate 2 having a first surface 3 and a first layer stack 4 that comprises a doped epitaxial semiconductor layer 5. The first layer stack 4 is configured and arranged to provide optical functionality if the photonic integrated circuit 1 is in use. The first layer stack 4 has a second surface 6 that is associated with the first surface 3 of the InP-based substrate 2, and a third surface 7 that is arranged to face away from the second surface 6.

The photonic integrated circuit 1 also comprises a second layer stack 8 that is configured and arranged to provide electrical functionality if the photonic integrated circuit 1 is in use. The second layer stack 8 comprises a first dielectric layer 9 that has a fourth surface 10 that is associated with the third surface 7 of the first layer stack 4, and a fifth surface 11 that is arranged to face away from the fourth surface 10. The second layer stack 8 also comprises an electrical ground shield 12 that has a sixth surface 13 that is associated with the fifth surface 11 of the first dielectric layer 9, and a seventh surface 14 that is arranged to face away from the sixth surface 13. The second layer stack 8 further comprises a second dielectric layer 15 that has an eighth surface 16 that is associated with the seventh surface 14 of the electrical ground shield 12, and a ninth surface 17 that is arranged to face away from the eighth surface 16.

The photonic integrated circuit 1 also comprises a first set of elongated tracks 18a, 18b of electrically conductive material that are associated with the ninth surface 17 of the second dielectric layer 15 of the second layer stack 8. The first set of elongated tracks 18a, 18b of electrically conductive material are configured and arranged to carry an RF signal if the photonic integrated circuit 1 is in use. The person skilled in the art will appreciate that the first set of elongated tracks of electrically conductive material can comprise any suitable number of elongated tracks. The two elongated tracks 18a, 18b that are shown in figure 1 are only a non-limiting example.

The photonic integrated circuit 1 also comprises at least one electrical bond pad 19 and at least one RF component 20 that are electrically associated with each other via the first set of elongated tracks 18a, 18b of electrically conductive material. The person skilled in the art will appreciate that the photonic integrated circuit 1 can comprise any suitable number of electrical bond pads 19 and RF components 20 that can be electrically associated using any suitable number of elongated tracks of the first set of elongated tracks of electrically conductive material. The one electrical bond pad 19, the one RF component 20, and the two elongated tracks 18a, 18b of electrically conductive material that are configured and arranged to associate the electrical bond pad 19 and the RF component 20 with each other are merely a non-limiting example.

It is noted that the first dielectric layer 9 of the second layer stack 8 of the photonic integrated circuit 1 shown in figure 1 is configured and arranged to provide DC electrical isolation between the electrical ground shield 12 and the first layer stack 4 if the photonic integrated circuit 1 is in use. In addition, the electrical ground shield 12 is configured and arranged to minimize or prevent overlap between an electric field that is caused by said RF signal and the doped epitaxial semiconductor layer 5 of the first layer stack 4 if the photonic integrated circuit 1 is in use. In this way, the photonic integrated circuit 1 comprises on-chip electrical interconnects or feedlines 18a, 18b that are implemented using a shielded on-chip electrical interconnect or feedline approach. From the above-described first exemplary, non-limiting embodiment of the photonic integrated circuit 1 it is clear that the elongated tracks 18a, 18b of the first set of elongated tracks of electrically conductive material are to be construed as on-chip electrical interconnects or feedlines.

The shielded on-chip electrical interconnect or feedline approach that is applied in the all exemplary, non-limiting embodiments of the photonic integrated circuit 1 according to the present invention shown in figures 1, 2, 3 and 4 minimizes or prevents an overlap between the doped epitaxial semiconductor layer 5 of the photonic integrated circuit 1 and the electric field of an RF signal that is carried by the on-chip electrical interconnects or feedlines 18a, 18b, if the photonic integrated circuit 1 is in use, without the need for applying at least one of the disruptive isolation trenches, impractically thick polymer layers and fragile air bridges discussed above in relation to the prior art. The shielded on-chip electrical interconnect or feedline approach enables long, i.e. in a range from 0.5mm to 5mm, low-loss on-chip electrical interconnects or feedlines 18a, 18b of desired impedance for use in photonic integrated circuits having increasingly complex layouts. The long shielded on-chip electrical interconnects or feedlines can route over photonic components such as on-chip optical waveguides without any performance penalty. It is noted that the shielded on-chip electrical interconnects or feedlines of the photonic integrated circuit according to the invention are suitable for application with any kind of RF component, for example Mach-Zehnder modulators (MZMs), electro-absorption modulators (EAMs) and RF photodiodes (RF PDs).

The electrically conductive material that is used for the elongated tracks 18a, 18b of the first set of elongated tracks can be any kind of electrically conductive material having any suitable composition and dimensions as long as a high-quality RF signal can be carried, if the photonic integrated circuit 1 is in use, between the bond pad 19 and the RF component 20 of the photonic integrated circuit 1. It is noted that the composition and the dimensions of the elongated tracks 18a, 18b of the first set of elongated tracks of electrically conductive material are dictated by a desired electrical impedance of the on-chip electrical interconnects or feedlines and fabrication process tolerances.

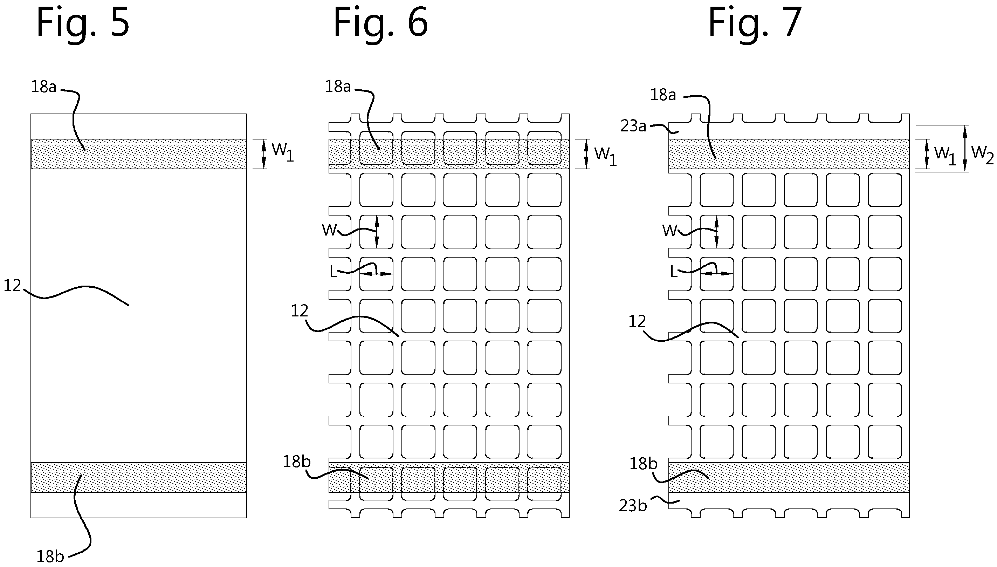

A practical example is that an elongated track 18a of the first set of elongated tracks is fabricated using electroplated gold as the electrically conductive material. The electroplated gold track 18a of the first set of elongated tracks can have a first width (W₁) (cfr. figures 5-7) as seen in a direction parallel to the InP-based substrate 2 of 10µm, and a first thickness (T₁) as seen in a direction perpendicular to the InP-based substrate 2 (cfr. figures 1-4) of 3µm to achieve an on-chip electrical interconnect or feedline having an impedance of 55 Ohm. It is noted that any other dimensions and composition of the electrically conductive material can be envisaged depending on the specific technical requirements of the photonic integrated circuit 1.

It is noted that the shielding performance of the electrical ground shield 12 is not influenced by the dimensions and/or composition of the elongated tracks 18a, 18b of the first set of elongated tracks of electrically conductive material. The electrical ground shield 12 can have a second thickness (T₂) in a range from 50nm to 4µm. A disadvantage of an electrical ground shield 12 having a second thickness (T₂) that is larger than 4µm is that topology and/or reliability issues can arise without any improvement in performance. A disadvantage of an electrical ground shield 12 having a second thickness (T₂) that is smaller than 50nm is that performance is compromised due to a too high resistivity.

It is noted that the degree of coupling between the electrical ground shield 12 and the electric field that is associated with the RF signal that, if the photonic integrated circuit 1 is in use, is carried by the first set of elongated tracks 18a, 18b of the first set of elongated tracks of electrically conductive material can be influenced by the composition and thickness of the second dielectric layer 15. For example, if the elongated tracks 18a, 18b of the first set of elongated tracks of electrically conductive material have a first thickness (T₁) of for example 3µm and the second dielectric layer 15 comprises benzocyclobutene (BCB) having a third thickness (T₃) as seen in the direction perpendicular to the InP-based substrate 2 of for example 3µm, the electric field associated with the RF signal that, if the photonic integrated circuit 1 is in use, is carried by the first set of elongated tracks 18a, 18b of electrically conductive material, can be considered as tightly coupled to the electrical ground shield 12. In addition, it is noted that the composition and the third thickness (T₃) of the second dielectric layer 15 can influence the impedance of the on-chip electrical interconnects or feedlines 18a, 18b. Therefore, the composition and the third thickness (T₃) of the second dielectric layer 15 need to be carefully chosen and/or controlled.

The above-mentioned example of a second dielectric layer 15 that comprises benzocyclobutene (BCB) and has a third thickness (T₃) of 3µm can be used to achieve on-chip electrical interconnects or feedlines having an impedance of 55 Ohm. It will be clear that the value for the impedance of the on-chip electrical interconnects or feedlines 18a, 18b and therefore the composition and dimensions of the second dielectric layer 15 depend on the actual use case of the photonic integrated circuit 1.

As mentioned above, if the photonic integrated circuit 1 is in use, the first dielectric layer 9 provides DC electrical isolation between the electrical ground shield 12 and the first layer stack 4 that comprises the doped epitaxial semiconductor layer 5. Although it would be sufficient if the first dielectric layer 9 has a fourth thickness (T₄) as seen in the direction perpendicular to the InP-based substrate 2 of for example 20nm, for planarization purposes it would be advantageous if the first dielectric layer 9 has a fourth thickness (T₄) of for example 3µm. As such, the first dielectric layer 9 would also have planarizing functionality that can improve the yield and reliability of the photonic integrated circuit 1.

It is noted that the electrically conductive material used for the elongated tracks 18a, 18b can comprise a metal that can be any metal that has a high electrical conductivity, is compatible with InP processing and does not give rise to yield and/or reliability issues. The metal can be a pure metal or an alloy. The pure metal can be gold or the alloy can comprise gold because of its high electrical conductivity and compatibility with InP processing.

Having regard to figures 1-4, it is noted that the first thickness (T₁) of the elongated tracks 18a, 18b of the first set of elongated tracks of electrically conductive material can be in a range from 0.5µm to 8µm. In addition, it is noted that the second thickness (T₂) of the electrical ground shield 12 can also be in a range from 0.5µm to 8µm. Although in accordance with the exemplary non-limiting embodiments of the photonic integrated circuit 1 shown in figures 1-4 the second thickness (T₂) is chosen to be equal to the first thickness (T₁), it is noted that the second thickness (T₂) can also be different from the first thickness (T₁) depending on the specific requirements for the photonic integrated circuit 1.

Figure 2 shows a schematic cross-section of a second exemplary, non-limiting embodiment of the photonic integrated circuit 1 according to the present invention, wherein the fourth surface 10 of the first dielectric layer 9 of the second layer stack 8 is associated with the third surface 7 of the first layer stack 4 via a third dielectric layer 26. It is noted that the first dielectric layer 9 and the third dielectric layer 26 comprise different materials. The first dielectric layer 9 can be a polymer layer, e.g. benzocyclobutene (BCB). The fourth thickness (T₄) of the first dielectric layer 9 can be in a range from 500nm to 3µm, for example 1.5µm. The third dielectric layer 26 can be an oxide containing material, e.g. silicon dioxide (SiO₂) having a fifth thickness (T₅) as seen in the direction perpendicular to the InP-based substrate 2. The fifth thickness (T₅) can be in a range from 20nm to 300nm, for example 150nm.

In accordance with the second exemplary, non-limiting embodiment of the photonic integrated circuit 1 shown in figure 2, the eighth surface 16 of the second dielectric layer 15 of the second layer stack 8 is associated with the seventh surface 14 of the electrical ground shield 12 of the second layer stack 8 via a fourth dielectric layer 27. It is noted that the second dielectric layer 15 and the fourth dielectric layer 27 comprise different materials. The second dielectric layer 15 can be a polymer layer, e.g. benzocyclobutene (BCB). The third thickness (T₃) of the second dielectric layer 15 can be in a range from 1µm to 5µm, for example 3µm. The fourth dielectric layer 27 can be an oxide containing material, e.g. silicon dioxide (SiO₂) having a sixth thickness (T₆) as seen in the direction perpendicular to the InP-based substrate 2. The sixth thickness (T₆) can be in a range from 50nm to 500nm, for example 300nm. As practical example, it is noted that 55 Ohm MZM feedlines 18a, 18b can be obtained by applying a second dielectric layer 15 that comprises BCB having a third thickness (T₃) of 3µm and a fourth dielectric layer 27 that comprises SiO2 having a sixth thickness (T₆) of 300 nm. It is clear that the third thickness (T₃) of the second dielectric layer 15 and the sixth thickness (T₆) of the fourth dielectric layer 27 will depend on the specific requirements for the photonic integrated circuit 1. However, for the sake of yield and/or reliability of the photonic integrated circuit 1 a minimum value of 50nm for a sum of the third thickness (T₃) and the sixth thickness (T₆) is recommended.

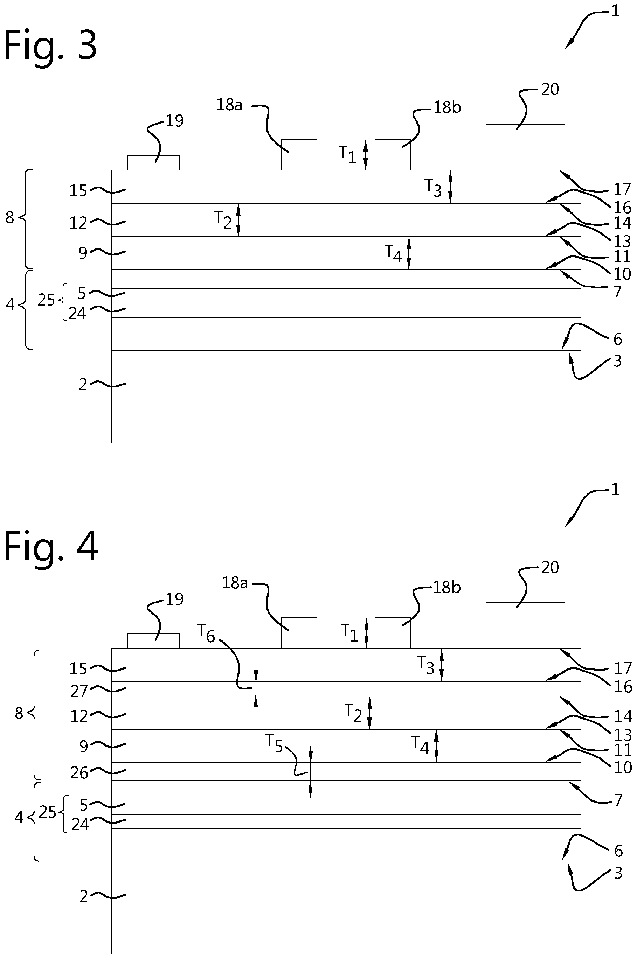

Figure 3 shows a schematic cross-section of a third exemplary, non-limiting embodiment of the photonic integrated circuit 1 according to the present invention. In comparison with the first exemplary, non-limiting embodiment of the photonic integrated circuit 1 shown in figure 1, the first layer stack 4 of the photonic integrated circuit 1 shown in figure 3 comprises a non-intentionally doped epitaxial semiconductor layer 24 that is arranged with respect to the doped epitaxial semiconductor layer 5 of the first layer stack 4 to provide the photonic integrated circuit 1 with an optical waveguide 25. The non-intentionally doped epitaxial semiconductor layer 24 can be an InₓGa₁₋ₓAs_{y}P_{1-y} core layer of the optical waveguide 25 and the doped epitaxial semiconductor layer 5 can be a p-type doped InP-based cladding layer of the optical waveguide 25.

Figure 4 shows a schematic cross-section of a fourth exemplary, non-limiting embodiment of the photonic integrated circuit 1 according to the present invention. In comparison with the second exemplary, non-limiting embodiment of the photonic integrated circuit 1 shown in figure 2, the first layer stack 4 of the photonic integrated circuit 1 shown in figure 4 comprises a non-intentionally doped epitaxial semiconductor layer 24 that is arranged with respect to the doped epitaxial semiconductor layer 5 of the first layer stack 4 to provide the photonic integrated circuit 1 with an optical waveguide 25. The non-intentionally doped epitaxial semiconductor layer 24 can be an InₓGa₁₋ₓAs_{y}P_{1-y} core layer of the optical waveguide 25 and the doped epitaxial semiconductor layer 5 can be a p-type doped InP-based cladding layer of the optical waveguide 25.

Based on all of the above, it is clear that photonic integrated circuits 1 in accordance with any one of the above-described exemplary non-limiting embodiments shown in figures 1-4 that comprise on-chip electrical interconnects or feedlines 18a, 18b that have been implemented in accordance with the shielded on-chip electrical interconnect or feedline approach, pre-empt the above-described problems associated with the typical approaches known from the prior art for reducing the above-mentioned problems associated with the implementation of on-chip electrical interconnects or feedlines in photonic integrated circuits having an increasingly complex layout. In particular, it is appreciated that the shielded on-chip electrical interconnect or feedline approach allows easier processing of photonic integrated circuits 1 according to the present invention. In addition, the shielded on-chip electrical interconnect or feedline approach provides a one-fits-all solution for the above-described specific situations, e.g. on-chip electrical interconnects that are arranged over doped epitaxial semiconductor layers and/or have to cross over on-chip optical waveguides.

Figure 5 shows a schematic top view of a portion of a photonic integrated circuit 1 according to the present invention, wherein two elongated tracks 18a, 18b of a first set of elongated tracks of electrically conductive material are arranged relative to a first exemplary, non-limiting embodiment of an electrical ground shield 12. It is noted that for the sake of clarity of representation, any dielectric layer that is arranged between the two elongated tracks 18a, 18b and the electrical ground shield 12 as seen in a direction perpendicular to the InP-based substrate 2 (cfr. figures 1, 2, 3 and 4) has been omitted.

As shown in figure 5, the electrical ground shield 12 of the second layer stack 8 is configured as a continuous sheet of electrically conductive material. A continuous sheet of electrically conductive material is the simplest implementation of the electrical ground shield 12 that provides the desired electrical shielding of the two elongated tracks 18a, 18b, i.e. the on-chip electrical interconnects or feedlines, from the doped epitaxial semiconductor layer 5 of the first layer stack 4 of the photonic integrated circuit 1 (cfr. figures 1, 2, 3 and 4). However, application of the electrically conductive material constituting the electrical ground shield 12 as a continuous sheet can introduce reliability issues. Especially if the continuous sheet has an area that covers most or all of the underlying layers, trapping of outgassed material from the underlying layers underneath the continuous sheet can lead to failure points that compromise the yield and reliability of the photonic integrated circuit 1.

It is noted that any kind of electrically conductive material having any suitable composition and dimensions can be used for establishing the electrical ground shield as a continuous sheet as long as the electrically conductive material can achieve electromagnetic shielding. Examples of suitable materials include metals, degenerate semiconductors, electrically conductive polymers, metal-organic frameworks and coordination polymers. Metal-organic frameworks are defined as crystalline compounds consisting of metal ions or clusters coordinated to often rigid organic molecules to form one-, two-, or three-dimensional structures that can be porous. Coordination polymers are inorganic or organometallic polymer structures comprising metal cation centers linked by ligands.

Figure 6 shows a schematic top view of a portion of a photonic integrated circuit 1 according to the present invention, wherein two elongated tracks 18a, 18b of the first set of elongated tracks of electrically conductive material are arranged relative to a second exemplary, non-limiting embodiment of the electrical ground shield 12. As mentioned above in relation to figure 5, any dielectric layer that is arranged between the two elongated tracks 18a, 18b and the electrical ground shield 12 as seen in a direction perpendicular to the InP-based substrate 2 (cfr. figures 1, 2, 3 and 4) has been omitted for the sake of clarity of representation.

As shown in figure 6, the electrical ground shield 12 of the second layer stack 8 is configured as a meshed grid of electrically conductive material. Configuring the electrical ground shield 12 as a meshed grid of electrically conductive material can remedy the above-mentioned disadvantage of establishing the electrical ground shield 12 as a continuous sheet of electrically conductive material. In addition, a meshed grid of electrically conductive material can offer improved fabrication tolerance because a continuous sheet of electrically conductive material can peel off more easily during the fabrication process than a meshed grid of electrically conductive material. Furthermore, the meshed grid of electrically conductive material can help to relieve additional stress or strain build-up in the electrical ground shield 12 during reliability testing of the photonic integrated circuit 1.

The meshed grid can be established by providing a continuous layer of an electrically conductive material with through-holes. The though-holes can be configured and arranged to provide the meshed grid with a uniform mesh size, i.e. the through-holes having a width (W) and a length (L) that are equal, as shown in figure 6, a non-uniform mesh size (not shown) or regions with a uniform mesh size and regions with a non-uniform mesh size (not shown). Another way of establishing a meshed grid is by interconnecting elongated tracks of an electrically conductive material using a mesh pattern. The elongated tracks of electrically conductive material can be arranged relative to each other to establish a uniform mesh size, i.e. the through-holes having a width (W) and a length (L) that are equal, a non-uniform mesh size (not shown) or regions with a uniform mesh size and regions with a non-uniform mesh size (not shown).

The meshed grid of electrically conductive material can have a maximum mesh size that is equal to one tenth of a wavelength of an RF signal that is carried by at least one of the two tracks 18a, 18b if the photonic integrated circuit 1 is in use. Typically, the maximum mesh size is in the order of a few millimeters. A minimum mesh size is usually dictated by process limitations. A minimum mesh size equal to zero would actually result in a continuous sheet of electrically conductive material.

As mentioned above, any kind of electrically conductive material having any suitable composition and dimensions can be used for establishing the meshed grid as long as the electrically conductive material can achieve electromagnetic shielding. Examples of suitable materials include metals, degenerate semiconductors, electrically conductive polymers, metal-organic frameworks and coordination polymers.

Figure 7 shows a schematic top view of a portion of a photonic integrated circuit 1 according to the present invention, wherein two elongated tracks 18a, 18b of the first set of elongated tracks of electrically conductive material are arranged relative to a third exemplary, non-limiting embodiment of the electrical ground shield 12. As mentioned above in relation to figures 5 and 6, any dielectric layer that is arranged between the two elongated tracks 18a, 18b and the electrical ground shield 12 as seen in a direction perpendicular to the InP-based substrate 2 (cfr. figures 1, 2, 3 and 4) has been omitted for the sake of clarity of representation.

As shown in figure 7, the electrical ground shield 12 of the second layer stack 8 is configured as a second set of elongated tracks 23a, 23b of electrically conductive material that are interconnected via a meshed grid of electrically conductive material. In this way the electrical ground shield 12 is established in a hybrid way, i.e. by using continuous tracks 23a, 23b of electrically conductive material that are interconnected by a meshed grid of electrically conductive material.

It is noted that any kind of electrically conductive material having any suitable composition and dimensions can be used for establishing the elongated tracks 23a, 23b of the second set of elongated tracks that are interconnected by the meshed grid of electrically conductive material as long as the electrically conductive material can achieve electromagnetic shielding. Examples of suitable materials include metals, degenerate semiconductors, electrically conductive polymers, metal-organic frameworks and coordination polymers.

As shown in figure 7, a first elongated track 23a of the second set of elongated tracks of electrically conductive material is arranged underneath a first elongated track 18a of the first set of elongated tracks of electrically conductive material, and a second elongated track 23b of the second set of elongated tracks of electrically conductive material is arranged underneath a second elongated track 18b of the first set of elongated tracks of electrically conductive material. It is noted that the way in which the first elongated track 23a and the second elongated track 23b of the second set of elongated tracks of electrically conductive material are arranged underneath the first elongated track 18a and the second elongated track 18b of the first set of elongated tracks of electrically conductive material as shown in figure 7 is exemplary and non-limiting in nature. In accordance with the third exemplary, non-limiting embodiment of the electrical ground shield 12shown in figure 7, the first elongated track 23a and the second elongated track 23b of the second set of elongated tracks of electrically conductive material are fully arranged underneath the first elongated track 18a and the second elongated track 18b of the first set of elongated tracks of electrically conductive material. As mentioned above, an advantage of the first elongated track 23a and the second elongated track 23b of the second set of elongated tracks of electrically conductive material is that they can be arranged to enable the first elongated track 18a and the second elongated track 18b of the first set of elongated tracks of electrically conductive material to cross for example optical waveguides.

Figure 7 shows that the first elongated track 18a of the first set of elongated tracks of electrically conductive material has a first width (W₁) as seen in a direction parallel to the InP-based substrate 2 and that the first elongated track 23a of the second set of elongated tracks of electrically conductive material that is arranged underneath the first elongated track 18a of the first set of elongated tracks of electrically conductive material has a second width (W₂) as seen in the direction parallel to the InP-based substrate 2. The second width (W₂) is larger than the first width (W₁). It is noted that the second width (W₂) can be at least 75% larger than the first width (W₁). The first width (W₁) can be in a range from 5µm to 15µm depending amongst others on specific requirements regarding the desired impedance of the first elongated track 18a of the first set of elongated tracks of electrically conductive material. Although not indicated in figure 7, the person skilled in the art will appreciate that the same holds for the second elongated tracks 18b of the first set of elongated tracks of electrically conductive material and the second elongated track 23b of the second set of elongated tracks of electrically conductive material.

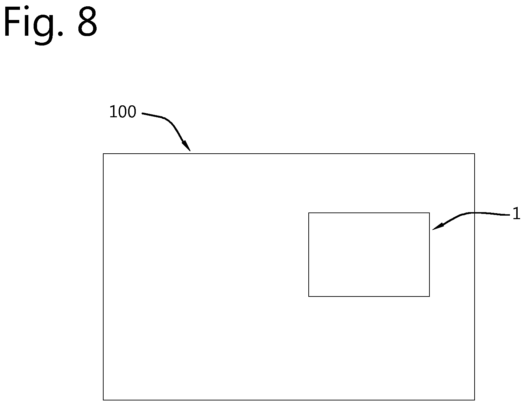

Figure 8 shows a schematic view of a first exemplary, non-limiting embodiment of an opto-electronic system 100 according to the present invention that comprises the photonic integrated circuit 1 according to the present invention. The opto-electronic system 100 can be used for example but not exclusively in telecommunication applications, LIDAR or sensor applications. The opto-electronic system 100 can for example be one of a transmitter, a receiver, a transceiver, a coherent transmitter, a coherent receiver and a coherent transceiver. Based on the above, the person skilled in the art will appreciate that the opto-electronic system 100 according to the present invention can benefit from the advantages provided by the photonic integrated circuit 1 according to the present invention.

The present invention can be summarized as relating to a photonic integrated circuit 1 comprising bond pads 19, RF components 20, a first layer stack 4 having a doped epitaxial semiconductor layer 5, a second layer stack 8 that is associated with the first layer stack 4, and a first set of elongated tracks 18a, 18b of electrically conductive material that are associated with the second layer stack 8 and in use of the photonic integrated circuit 1 can carry an RF signal between the bond pads 19 and the RF components 20. The second layer stack 8 comprises an electrical ground shield 12 that is sandwiched between a first dielectric layer 9 and a second dielectric layer 15. In use of the photonic integrated circuit 1, the electrical ground shield 12 minimizes or prevents overlap between an electric field caused by said RF signal and said doped epitaxial semiconductor layer 5. The invention also relates to an opto-electronic system 100 comprising said photonic integrated circuit 1.

It will be clear to a person skilled in the art that the scope of the present invention is not limited to the examples discussed in the foregoing but that several amendments and modifications thereof are possible without deviating from the scope of the present invention as defined by the attached claims. In particular, combinations of specific features of various aspects of the invention may be made. An aspect of the invention may be further advantageously enhanced by adding a feature that was described in relation to another aspect of the invention. While the present invention has been illustrated and described in detail in the figures and the description, such illustration and description are to be considered illustrative or exemplary only, and not restrictive.

The present invention is not limited to the disclosed embodiments. Variations to the disclosed embodiments can be understood and effected by a person skilled in the art in practicing the claimed invention, from a study of the figures, the description and the attached claims. In the claims, the word "comprising" does not exclude other steps or elements, and the indefinite article "a" or "an" does not exclude a plurality. The mere fact that certain measures are recited in mutually different dependent claims does not indicate that a combination of these measures cannot be used to advantage. Any reference numerals in the claims should not be construed as limiting the scope of the present invention.

## Claims

1. A photonic integrated circuit (1) comprising:
- an InP-based substrate (2) having a first surface (3);
- a first layer stack (4) that comprises a doped epitaxial semiconductor layer (5), the first layer stack (4) being configured and arranged to provide optical functionality if the photonic integrated circuit (1) is in use, the first layer stack (4) having:
• a second surface (6) that is associated with the first surface (3) of the InP-based substrate (2); and
• a third surface (7) that is arranged to face away from the second surface (6); and
- a second layer stack (8) that is configured and arranged to provide electrical functionality if the photonic integrated circuit (1) is in use, the second layer stack (8) comprising:
• a first dielectric layer (9) having:
∘ a fourth surface (10) that is associated with the third surface (7) of the first layer stack (4); and
∘ a fifth surface (11) that is arranged to face away from the fourth surface (10);
• an electrical ground shield (12) having:
∘ a sixth surface (13) that is associated with the fifth surface (11) of the first dielectric layer (9); and
∘ a seventh surface (14) that is arranged to face away from the sixth surface (13);
• a second dielectric layer (15) having:
∘ an eighth surface (16) that is associated with the seventh surface (14) of the electrical ground shield (12); and
∘ a ninth surface (17) that is arranged to face away from the eighth surface (16);
- a first set of elongated tracks (18a, 18b) of electrically conductive material that are associated with the ninth surface (17) of the second dielectric layer (15) of the second layer stack (8), the first set of elongated tracks (18a, 18b) of electrically conductive material being configured and arranged to carry an RF signal if the photonic integrated circuit (1) is in use; and
- at least one electrical bond pad (19) and at least one RF component (20) that are electrically associated with each other via the first set of elongated tracks (18a, 18b) of electrically conductive material;
wherein the first dielectric layer (9) of the second layer stack (8) is configured and arranged to provide DC electrical isolation between the electrical ground shield (12) and the first layer stack (4) if the photonic integrated circuit (1) is in use, and wherein the electrical ground shield (12) is configured and arranged to minimize or prevent overlap between an electric field that is caused by said RF signal and the doped epitaxial semiconductor layer (5) of the first layer stack (4) if the photonic integrated circuit (1) is in use.

2. The photonic integrated circuit (1) according to claim 1, wherein the electrical ground shield (12) of the second layer stack (8) is configured as a continuous sheet of electrically conductive material.

3. The photonic integrated circuit (1) according to claim 1, wherein the electrical ground shield (12) of the second layer stack (8) is configured as a meshed grid of electrically conductive material.

4. The photonic integrated circuit (1) according to claim 3, wherein the meshed grid of electrically conductive material is configured to have a maximum mesh size that is equal to one tenth of a wavelength of said RF signal that is carried by the first set of elongated tracks (18a, 18b) of electrically conductive material if the photonic integrated circuit (1) is in use.

5. The photonic integrated circuit (1) according to claim 1, wherein the electrical ground shield (12) of the second layer stack (8) is configured as a second set of elongated tracks (23a, 23b) of electrically conductive material that are interconnected via a meshed grid of electrically conductive material.

6. The photonic integrated circuit (1) according to claim 5, wherein an elongated track of the second set of elongated tracks (23a, 23b) of electrically conductive material is arranged underneath an elongated track of the first set of elongated tracks (18a, 18b) of electrically conductive material.

7. The photonic integrated circuit (1) according to claim 6, wherein a respective elongated track of the second set of elongated tracks (23a, 23b) of electrically conductive material that is arranged underneath a respective elongated track of the first set of elongated tracks (18a, 18b) of electrically conductive material has a respective second width, W₂, as seen in a direction parallel to the InP-based substrate (2), and the respective elongated track of the first set of elongated tracks (18a, 18b) of electrically conductive material has a first width, W₁, as seen in the direction parallel to the InP-based substrate (2), wherein the second width, W₂, is larger than the first width, W₁.

8. The photonic integrated circuit (1) according to any one of the claims 1 to 7, wherein the electrically conductive material comprises metal.

9. The photonic integrated circuit (1) according to claim 8, wherein the metal comprises gold.

10. The photonic integrated circuit (1) according to any one of the claims 1 to 7, wherein the electrically conductive material is gold.

11. The photonic integrated circuit (1) according to any one of the claims 1 to 10, wherein the first layer stack (4) comprises a non-intentionally doped epitaxial semiconductor layer (24) that is arranged with respect to said doped epitaxial semiconductor layer (5) to provide the photonic integrated circuit (1) with an optical waveguide (25).

12. The photonic integrated circuit (1) according to claim 11, wherein the non-intentionally doped epitaxial semiconductor layer (24) is an InₓGa₁₋ₓAs_{y}P_{1-y} core layer of the optical waveguide (25) and the doped epitaxial semiconductor layer (5) is a p-type doped InP-based cladding layer of the optical waveguide (25).

13. The photonic integrated circuit (1) according to any one of the claims 1 to 12, wherein the fourth surface (10) of the first dielectric layer (9) of the second layer stack (8) is associated with the third surface (7) of the first layer stack (4) via a third dielectric layer (26), wherein the first dielectric layer (9) and the third dielectric layer (26) comprise different materials.

14. The photonic integrated circuit (1) according to any one of the claims 1 to 13, wherein the eighth surface (16) of the second dielectric layer (15) of the second layer stack (8) is associated with the seventh surface (14) of the electrical ground shield (12) of the second layer stack (8) via a fourth dielectric layer (27), wherein the second dielectric layer (15) and the fourth dielectric layer (27) comprise different materials.

15. An opto-electronic system (100) comprising a photonic integrated circuit (1) according to any one of the claims 1 to 14, wherein the opto-electronic system (100) is one of a transmitter, a receiver, a transceiver, a coherent transmitter, a coherent receiver and a coherent transceiver.
